# EUROPÄISCHE PATENTSCHRIFT

(11) **EP 0 911 886 B1**
(45) Veröffentlichungstag und Bekanntmachung des Hinweises auf die Patenterteilung: **07.06.2017**
(21) Anmeldenummer: 98119536.5
(22) Anmeldetag: 15.10.1998
(51) Int. Cl.: H01L 33/00, H01L 31/0203

(54) **Verfahren zur Herstellung eines optoelektronischen Bauelements**
Manufacturing method for an optoelectronic device
Méthode de fabrication d'un dispositif opto-électronique

(30) Priorität: 23.10.1997 DE 19746893
(43) Veröffentlichungstag der Anmeldung: 28.04.1999
(60) Teilanmeldung: 10179517.7
(73) Patentinhaber: OSRAM Opto Semiconductors GmbH, 93055 Regensburg (DE)
(72) Erfinder: Brunner, Herbert, 93047 Regensburg (DE); Hurt, Hans, 93049 Regensburg (DE)
(74) Vertreter: Epping - Hermann - Fischer

(56) Entgegenhaltungen:
- EP-A- 0 062 300
- EP-A- 0 493 051
- EP-A- 0 641 152
- DE-A- 3 128 187
- JP-A- H07 202 271
- US-A- 5 525 205
- PATENT ABSTRACTS OF JAPAN vol. 010, no. 275 (E-438), 18. September 1986 (1986-09-18) -& JP 61 096778 A (NEC CORP), 15. Mai 1986 (1986-05-15)
- PATENT ABSTRACTS OF JAPAN vol. 014, no. 065 (E-0884), 6. Februar 1990 (1990-02-06) -& JP 01 283883 A (MATSUSHITA ELECTRIC IND CO LTD), 15. November 1989 (1989-11-15)

## Beschreibung

Die Erfindung bezieht sich auf ein optoelektronisches Bauelement mit einem strahlungsempfangenden oder strahlungsemittierenden Halbleiterchip, der an bzw. auf einem Sockelteil befestigt und mit wenigstens zwei für die elektrische Kontaktgabe des Bauelementes dienenden Elektrodenanschlüssen aus einem elektrisch leitenden Anschluss-Material verbunden ist, und bezieht sich ferner auf ein Verfahren zur Herstellung eines solchen optoelektronischen Bauelementes.

Derartige optoelektronische Halbleiterbauelemente werden in Massenstückzahlen hergestellt und dienen als Wandler optischer Signale oder Energie in elektrische Signale oder Energie bzw. umgekehrt. Strahlungsempfänger bzw. strahlungsempfindliche Bauelemente sind beispielsweise Photodioden oder Phototransistoren. Zu den Sendern bzw. Strahlung aussendenden Bauelementen gehören (sichtbares) Licht emittierende Dioden (LED) und Infrarotstrahlung emittierende Dioden (IRED). Diese optoelektronischen Bauelemente werden zweckmäßig im Waferverband hergestellt und nach Fertigstellung in Form von quaderförmigen Chips aus dem Waferverband vereinzelt. Die fertigen Halbleiterchips werden dann je nach Verwendungszweck auf einem geeigneten Träger befestigt, kontaktiert und in eine Umhüllung aus transparentem Kunststoff eingebettet. Neben einem Schutz für den Halbleiterchip sowie den Kontaktdrähten kommt der Kunststoffumhüllung daneben auch die Funktion einer in bzw. auf dem Chip verbesserten Strahlungseinkopplung bzw. Strahlungsauskopplung zu.

Neben den allseits bekannten radialen Bauformen mit einem Plastikgehäuse und nach einer Seite herausragenden, länglichen Elektrodenanschlüssen sind insbesondere auch für die Oberflächenmontage geeignete Bauformen von Leuchtdioden bekannt, bei denen ein sogenanntes Leadframe als vorgefertigtes Trägerteil für den Halbleiterchip vorgesehen ist, und die Elektrodenanschlüsse als aus dem Plastikgehäuse seitlich herausgeführten und abgebogenen Beinchen ausgebildet ist. Bei der Herstellung solcher LEDs für die Oberflächenmontage wird ein endlos gestanztes Leiterband mit einem hochtemperaturfesten Thermoplast umspritzt. Bei einer weiteren Verfahrenstechnik wird die Leuchtdiode erst nach der Vergussfertigung in einen für die Oberflächenmontage geeigneten Halter eingebaut.

Aus der DE 31 28 187 A1 ist ein optoelektronisches Bauelement entsprechend dem Oberbegriff des Anspruches 1 bekannt, bei dem zwei auf einem Träger flächig aufgebrachte, mit dem Halbleiterkörper verbundene Anschlüsse vorgesehen sind,'die sich von der den Halbleiterkörper tragenden Außenfläche des Trägers bis auf wenigstens eine weitere Außenfläche des Trägers erstrecken und dort eine Anschlusskontaktfläche bilden.

Aus der DE 196 21 124 A1 ist ein optoelektronischer Wandler mit einem auf einer Trägereinheit befestigten Halbleiterchip bekannt. Die Trägereinheit besitzt einen Chipmontagebereich, dem eine Anzahl von Anschlussteilen zugeordnet ist. Diese Anschlussteile sind mit elektrischen Anschlussflächen versehen, die eine Ebene definieren, deren Abstand zum Chipmontagebereich größer ist als die maximale Höhe des Halbleiterchips gegebenenfalls einschließlich sämtlicher Anschlussleiter und/oder Abdeckmittel bezogen auf den Chipmontagebereich.

Aus der Jap. J. Appl. Physics, Bd. 27, 1988, S. L1764 - L1767 ist ein Verfahren bekannt, bei dem ein isolierendes Substrat mit einer dünnen Beschichtung aus Kupfer durch Abscheidung aus einer Flüssigkeit chemisch und ohne Einwirkung eines äußeren Stromflusses überzogen wird ("electroless plating").

Sodann wird die Kupfer-Beschichtung selektiv geätzt mit Hilfe der Photolithographie, wobei eine Maskenschicht abgeschieden und strukturiert wird, wodurch von dem Maskenmaterial abgedeckte und nicht abgedeckte Bereiche der Beschichtung ausgewiesen werden, und selektiv die nicht durch das Material der Maskenschicht abgedeckten Bereiche durch Ätzen entfernt werden.

In der Druckschrift EP 0 493 051 A1 ist ein Bauelement mit einer Ausnehmung für einen Licht emittierenden Chip und einer Ausnehmung für einen Licht empfangenden Chip beschrieben, bei dem in den Ausnehmungen eine metallische abgeschiedene Verdrahtung ausgebildet ist.

Die Druckschrift EP 0 062 300 A2 betrifft ein Verfahren zur Herstellung von Leiterplatten.

Aus der Druckschrift JP 07-202271 A ist ein Bauelement bekannt, bei dem ein Licht emittierender Diodenchip in einer Ausnehmung einer Platte angeordnet ist und der Chip über eine Drahtverbindung mit einem Muster auf der Oberfläche der Platte verbunden ist.

In der Druckschrift US 5,525,205 A wird ein Verfahren zur Ausbildung einer Schaltung durch Laser angegeben.

Der Erfindung liegt die Aufgabe zugrunde, ein optoelektronisches Bauelement, insbesondere SMT-Optobauelement (SMT = Surface Mounted Technologie) und ein Verfahren zu seiner Herstellung anzugeben, welches bei weiterhin verringerter Baugröße des Bauelementes insbesondere bei hohen Stückzahlen auch bei unterschiedlichen Bauformen eine kostengünstige Herstellung ermöglicht.

Das erfindungsgemäße Verfahren zur Herstellung eines optoelektronischen Bauelementes zeichnet sich bei einer ersten Ausgestaltung dadurch aus, dass das Sockelteil mit einer dünnen Beschichtung aus dem elektrisch leitenden Anschluss-Material durch Abscheidung aus einer Flüssigkeit, insbesondere chemisch und ohne Einwirkung eines äußeren elektrischen Stromflusses, überzogen wird, die dünne Beschichtung des Sockelteils strukturiert wird und hierbei einzelne, elektrisch voneinander isolierte Bereiche der Beschichtung gefertigt werden, selektiv auf einigen vorbestimmten der sonach gefertigten Bereichen der dünnen Beschichtung eine weitere dünne Schicht aus einem Hilfsmaterial durch galvanische Abscheidung unter der Wirkung eines äußeren elektrischen Stromflusses abgeschieden wird, wodurch die Schichtdicke dieser vorbestimmten Bereiche der Beschichtung verstärkt wird, und die nicht verstärkten Bereiche der Sockelteil-Beschichtung selektiv durch Ätzen entfernt werden.

Ein weiteres erfindungsgemäßes Verfahren zeichnet sich dadurch aus, dass das Sockelteil mit einer dünnen Beschichtung aus dem elektrisch leitenden Anschluss-Material durch Abscheidung aus einer Flüssigkeit, insbesondere chemisch und ohne Einwirkung eines äußeren elektrischen Stromflusses, überzogen wird, auf der dünnen Sockelteil-Beschichtung eine Maskenschicht abgeschieden wird, die Maskenschicht strukturiert wird, wodurch von dem Maskenmaterial abgedeckte und nicht abgedeckte Bereiche der Sockelteil-Beschichtung ausgewiesen werden, und selektiv die nicht durch das Material der Maskenschicht abgedeckten Bereiche durch Ätzen entfernt werden.

Die mit der Erfindung erzielten Vorteile bestehen insbesondere darin, dass durch die Verwendung eines vorgefertigten Kunststoff-Sockelteils, vorzugsweise Kunststoff-Spritzteils, auf dem die für die elektrische Kontaktgabe das Bauelementes dienenden Elektrodenanschlüsse in einer strukturierten Beschichtungstechnik aufgebracht werden, Optobauelemente für die Oberflächenmontagetechnik (SMT) mit geringeren Bauhöhen mit wesentlich geringen Fertigungskosten hergestellt werden können. Aufgrund einer flexiblen Prozessführung ermöglicht die Erfindung die Herstellung unterschiedlichster Bauformen und Elektrodenanschlussformen; auf ebenso kostengünstige und einfache Weise sind mehrere Bauelemente im Verbund, sogenannte Arrays herstellbar. Eine breite Palette von Bauelementmodifikationen kann mit nur einem Sockelteil abgedeckt werden. Dieses Sockelteil ist beispielsweise bei einer LED als Bauelement in seiner Gestaltung wesentlich einfacher als die herkömmlichen LED-Träger mit Leadframe bzw. mit geprägtem Reflektor.

Weitere Zweckmäßigkeiten der Erfindung ergeben sich aus den Unteransprüchen.

Anhand der Zeichnung werden bevorzugte Ausführungsbeispiele der Erfindung weiter erläutert. Es zeigt:
- Figur 1: eine schematische Schnittansicht eines fertiggestellten optoelektronischen Bauelementes in der Form einer lichtemittierenden Diode mit Linse für die Oberflächenmontage;
- Figur 2: eine schematische Draufsicht der im Plattenverbund gefertigten LEDs;
- Figuren 3A bis 3C: in schematischen Ansichten die aufeinander folgenden Prozess-Schritte zur Fertigung des Sockelteils nach einem ersten Ausführungsbeispiel der Erfindung; und
- Figuren 4A bis 4C: in schematischen Ansichten die aufeinander folgenden Prozess-Schritte zur Fertigung des Sockelteils nach einem zweiten Ausführungsbeispiel der Erfindung.

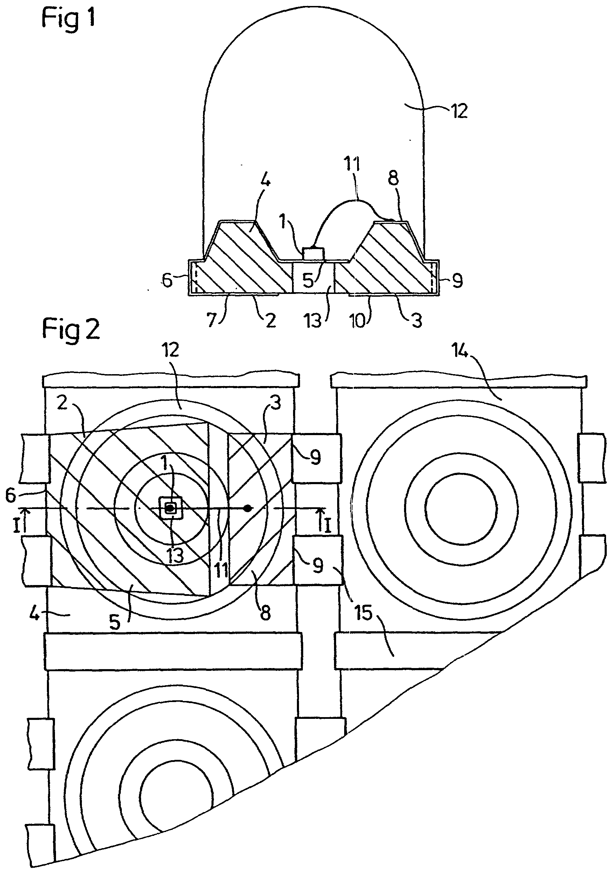

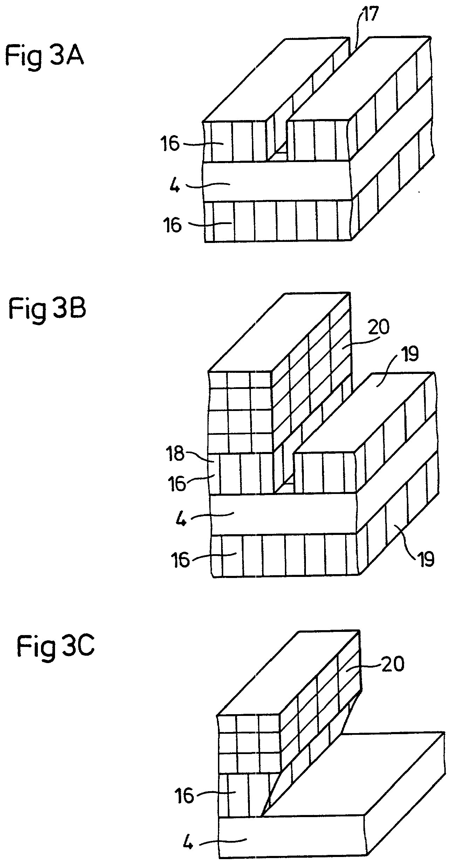

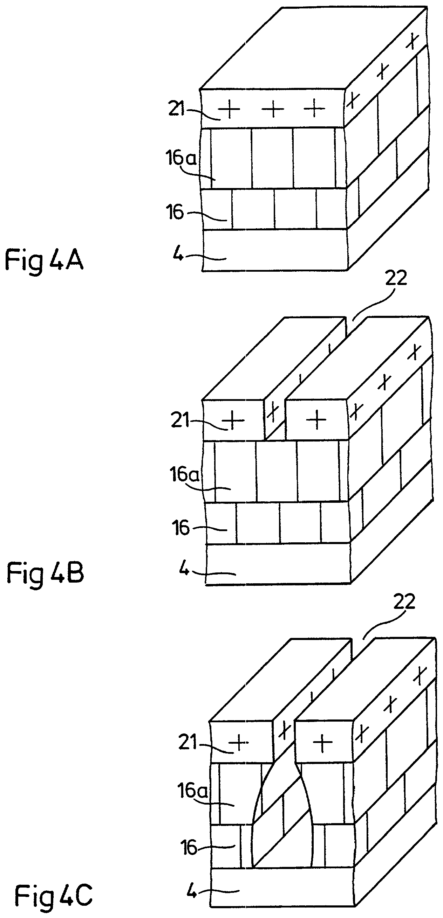

In Figur 1 ist als Beispiel eines optoelektronischen Bauelements eine Lumineszenz- bzw. Leuchtdiode (LED) dargestellt. Die LED besitzt einen Halbleiterchip 1 als strahlungsemittierendes Element. Ein Sockelteil 4 als Chipträger ist auf vorbestimmten Abschnitten seiner äußeren Oberflächen mit zwei Elektrodenanschlüssen 2, 3 aus einem elektrisch leitenden Anschluss-Material, welches insbesondere Kupfer aufweist, beschichtet. Hierbei erstreckt sich die elektrisch leitende Fläche des einen Elektrodenanschlusses 2 ausgehend von einem Abschnitt 5 auf der dem Halbleiterchip 1 zugewandten Oberseite des Sockelteils 4 über randseitige Abschnitte 6 hinweg bis zu Abschnitten 7 auf der Unterseite des Sockelteils 4. Entsprechend erstreckt sich die Fläche des zweiten Elektrodenanschlusses 3 auf der anderen Seite des Sockelteils 4 ausgehend von einem Abschnitt 8 über randseitige Abschnitte 9 bis zu Abschnitten 10 auf der Unterseite des Sockelteils 4. Der Halbleiterchip 1 ist auf dem Abschnitt 5 des Elektrodenanschlusses 2 zweckmäßig mittels eines geeigneten Leitklebers befestigt. Die Kontaktierung des Chips 1 mit dem zweiten Elektrodenanschluss 3 erfolgt über einen Bonddraht 11. Ein Linsenteil 12 aus transparentem Kunststoff ist auf dem Sockelteil 4 geformt. Der Sockelteil 4 weist eine eingearbeitete Wärmesenke 13 auf, die aus Kupfer sein kann. Zweckmäßigerweise werden in einem Arbeitsgang gleichzeitig mehrere optoelektronische Bauelemente bzw. Sockelteile mit den Elektrodenanschlüssen gefertigt. Figur 2 zeigt einen zu diesem Zweck im Spritzgussverfahren vorgefertigten, plattenförmigen Trägerkörper 14 aus einem geeigneten Hochtemperatur-Thermoplastmaterial, der mit Durchbrüchen 15 zwischen den später zu einzelnden Sockelteilen 4 versehen ist, an denen einerseits ein Transportwerkzeug zur Beförderung des Trägers 14, und andererseits ein Trennwerkzeug zum Vereinzeln der Bauelemente angreifen kann. In dem plattenförmigen Trägerkörper 14 der Sockelteile werden zunächst die Elektrodenanschlüsse 2, 3 gefertigt, die als Leiterbahnen für die Chipmontage und für die elektrische Kontaktgabe des Bauelementes für eine Oberflächenmontage (SMT) dienen. Die Fertigung der Elektrodenanschlüsse folgt nach einem anhand der Figuren 3A bis 3C nachstehend erläuterten ersten Ausführungsbeispiel oder anhand einem in den Figuren 4A bis 4C erläuterten zweiten Ausführungsbeispiel.

Nach der Fertigstellung des Sockelteils 4 mit Elektrodenanschlüssen 2, 3 wird - noch im Verbund des Körpers 14 - der Halbleiterchip 1 gebondet und der Anschlussdraht 11 kontaktiert. Das Sockelteil ist so beschaffen, dass auch mehrere Halbleiterchips pro Bauteil montiert werden können, wobei in diesem Fall in der Regel mehr als zwei Elektrodenanschlüsse benötigt werden. Daran anschließend wird die Linse 12 aufgebracht. Dies wird unter Einsatz einer geeignet ausgebildeten Formenplatte durchgeführt, deren Formen die Linsenkörper bilden, und welche zum Chipträgerverband ausgerichtet werden kann. Die einzelnen Formen werden beispielsweise mit Epoxidharz gefüllt, und das Chipträgersubstrat mit dem Gesicht nach unten auf die Formenplatte zentriert. Nach dem Anhärten des Epoxidharzes für die Linsen wird das Substrat entformt, wobei die Epoxidharzlinsen bei Bedarf noch nachgehärtet werden können. Daran anschließend wird der mit den Linsen versehene Chipträgerkörper 14 vermittels eines Sägeprozesses in Einzelbauteile oder auch Arrays vereinzelt. Für eine optimale Beschaltung können die "Leiterbahnen" der Elektrodenanschlüsse 2, 3 ebenfalls mittels Sägen durchgetrennt werden. Anschließend können die vereinzelten Bauelemente bzw. Arrays unter dem Einsatz eines Automaten getestet und verpackt werden. Die Verpackung kann entweder in sogenannten Tapes oder auch in Tubes, insbesondere im Falle von Arrays, erfolgen. Darüber hinaus können weitere Verpackungen zum Einsatz gelangen, beispielsweise vermittels einer Bauteilträgerfolie oder dergleichen. Anspruchsgemäß besteht der Chipträgerkörper 14 aus einem Kunststoff-Material. In einer nicht beanspruchten Ausführung kann im Prinzip auch eine Metallplatte Verwendung finden, die zur elektrischen Isolierung entweder mit Einsätzen versehen ist oder vermittels einer Kunststoff--Folie beschichtet ist. Hierbei kann der Trägerkörper 14 im Sinne einer weiteren Reduktion der Fertigungskosten auch als wiederverwendbares Bauteil ausgebildet sein.

Weiterhin ist die Formenplatte zur Fertigung der Linsen so gestaltet, dass die einzelnen Linsenformen miteinander verbunden sind, und beim Gießen der Linsen ein Niveauabgleich des Gussmittels stattfinden kann, um eine genaue Vergusshöhe zu gewährleisten. Zusätzlich können Überlaufreservoires angebracht sein. Zwischen den Formen für die Linsen können darüber hinaus Bohrungen für Auswerferstifte vorhanden sein, um die Entformung zu ermöglichen bzw. zu vereinfachen. Um den Entformungsstress zu minimieren und die Genauigkeit zu maximieren sollten die Ausdehnungskoeffizienten von Chipträgerkörper 14 und Formenplatte möglichst gut angepasst sein, zweckmäßig ist hierbei die Verwendung eines Trägerkörpers aus LCP-Material (flüssigkristallines Polymer) und einer Formenplatte aus Metall.

Die Figuren 3A bis 3C zeigen schematisch die aufeinander folgenden Prozess-Schritte zur Fertigung der in Verbund befindlichen Sockelteile 4 mit den Elektrodenanschlüssen gemäß einem ersten Ausführungsbeispiel der Erfindung. Nach der Figur 3A wird das Sockelteil 4 in einem ersten Schritt allseitig mit einer dünnen Beschichtung 16 aus dem elektrisch leitenden Anschluss-Material, insbesondere Kupfer, durch Abscheidung aus einer Flüssigkeit überzogen. Diese Abscheidung erfolgt chemisch, d.h. ohne Einwirkung eines äußeren elektrischen Stromflusses. Daran anschließend erfolgt die Strukturierung der Sockelteil-Beschichtung 16 unter der Einwirkung eines Teilchen- oder Lichtstrahls, insbesondere Laserstrahls. An den Stellen, wo der Laserstrahl geführt wird, entstehen durch Abdampfung des Anschluss-Materials bis zum Material des Sokkelteils 4 reichende Strukturierungsgräben 17, die jeweils benachbarte Bereiche des Anschluss-Materials 16 elektrisch voneinander isolieren. In einem darauf folgenden Arbeitsschritt wird gemäß Figur 3B selektiv auf einigen vorbestimmten der solchermaßen gefertigten Bereichen 18 eine weitere dünne Schicht 20 aus einem Hilfsmaterial, insbesondere wiederum Kupfer aufweisend, durch galvanische Abscheidung aufgebracht, d.h. unter der Wirkung eines äußeren elektrischen Stromflusses durch den betroffenen Bereich 18. Auf diese Weise wird die Schichtdicke dieses Bereiches 18 um den Wert der Schichtdicke des Materials 20 verstärkt, während die nicht mit einem elektrischen Strom beaufschlagten Bereiche 19 unverändert bleiben. Daran anschließend können nach Figur 3C die nicht verstärkten Bereiche 19 der Sockelteil-Beschichtung vollständig durch nass-chemisches Ätzen entfernt werden, wobei nach dem Ätzen die Schichtdicke des Bereiches 20 etwas verringert wird.

Die Figuren 4A bis 4C zeigen in aufeinander folgenden Arbeitsschritten ein zweites Ausführungsbeispiel zur Fertigung der Sockelteile 4 mit Elektrodenanschlüssen 2, 3. Wiederum wird in einem ersten Schritt allseitig eine dünne Beschichtung 16 aus dem elektrisch leitenden Anschluss-Material auf chemischem Wege, d.h. ohne Einwirkung eines äußeren elektrischen Stromflusses aufgebracht, wobei in den Figuren 4A bis 4C aus Gründen der übersichtlicheren Darstellung die Beschichtung lediglich auf der Oberseite des Sockelteils 4 gezeigt ist, und eine nähere Darstellung der Unterseite weggelassen ist. Die Stärke der Beschichtung 16 kann durch (chemisches oder auch galvanisches) Aufbringen von weiterem Material 16a verstärkt werden. Es folgt eine vorzugsweise chemische Beschichtung mit einer dünnen Maskenschicht 21, beispielsweise aus Zinn-Material. Die Maskenschicht 21 wird nach Figur 4B strukturiert, und zwar unter der Einwirkung eines Teilchen- oder Lichtstrahls, insbesondere Laserstrahls. Nach Figur 4C wird die Struktur der Maske 21 nass-chemisch auf die Beschichtung 16, 16a übertragen, d.h. es werden selektiv die nicht durch das Material der Maskenschicht 21 abgedeckten Bereiche durch Ätzen entfernt. Auf diese Weise kann mit vergleichsweise geringen Fertigungskosten die gewünschte Struktur der flächenhaften Elektrodenanschlüsse 2 und 3 hergestellt werden.

### Bezugszeichenliste

- 1: Halbleiterchip
- 2, 3: Elektrodenanschlüsse
- 4: Sockelteil
- 5, 6, 7, 8, 9, 10: Abschnitte
- 11: Bonddraht
- 12: Linsenteil
- 13: Wärmesenke
- 14: Trägerkörper
- 15: Durchbrüche
- 16: Beschichtung
- 17: Strukturierungsgräben
- 18, 19, 20: Bereiche
- 21: Maskenschicht

## Patentansprüche

1. Verfahren zur Herstellung eines optoelektronischen Bauelementes mit einem strahlungsempfangenden oder strahlungsemittierenden Halbleiterchip (1), der an oder auf einem Sockelteil (4) befestigt und mit wenigstens zwei für die elektrische Kontaktgabe des Bauelementes dienenden Elektrodenanschlüssen (2, 3) aus einem elektrisch leitenden Anschluss-Material verbunden ist, wobei
- die Elektrodenanschlüsse durch eine auf den äußeren Oberflächen des Sockelteils (4) abgeschiedene strukturierte, dünne Beschichtung (16) ausgebildet werden,
- das Sockelteil (4) ein Kunststoff-Sockelteil ist, in das eine Wärmesenke (13) aus thermisch leitendem Material eingearbeitet ist,
- die Wärmesenke sich in thermischem Kontakt mit dem Halbleiterchip (1) befindet,
- sich ein erster Elektrodenanschluss (2) der Elektrodenanschlüsse (2, 3) ausgehend von einem Abschnitt (5) auf einer dem Halbleiterchip zugewandten Oberseite des Sockelteils über randseitige Abschnitte (6) hinweg bis zu Abschnitten (7) auf der Unterseite des Sockelteils (4) erstreckt, sich ein zweiter Elektrodenanschluss (3) der Elektrodenanschlüsse (2, 3) ausgehend von der dem Halbleiterchip zugwandten Oberseite des Sockelteils (4) über randseitige Abschnitte des Sockelteils (4) bis zur Unterseite des Sockelteils (4) erstreckt und der Halbleiterchip auf dem Abschnitt (5) auf der Oberseite des ersten Elektrodenanschlusses (2) befestigt ist,
- das Sockelteil (4) mit der dünnen Beschichtung (16) aus dem elektrisch leitenden Anschluss-Material durch chemische Abscheidung aus einer Flüssigkeit ohne Einwirkung eines äußeren elektrischen Stromflusses, überzogen wird,
- die dünne Beschichtung (16) des Sockelteils (4) strukturiert wird und hierbei einzelne, elektrisch voneinander isolierte Bereiche (18, 19) der Beschichtung (16) gefertigt werden,
- selektiv auf einigen vorbestimmten (18) der sonach gefertigten Bereichen der dünnen Beschichtung (16) eine weitere dünne Schicht (20) aus einem Hilfsmaterial durch galvanische Abscheidung unter der Wirkung eines äußeren elektrischen Stromflusses abgeschieden wird, wodurch die Schichtdicke dieser vorbestimmten Bereiche (18) der Beschichtung (16) verstärkt wird,
- die nicht verstärkten Bereiche (19) der Sockelteil-Beschichtung selektiv durch Ätzen entfernt werden, und
- gleichzeitig mehrere optoelektronische Bauelemente gefertigt werden, und jeweils eine Linse (12) aufgebracht wird, wobei zur Fertigung der Linsen eine Formenplatte zum Gießen der Linsen eingesetzt wird, die so gestaltet ist, dass die einzelnen Linsenformen, die die Linsenkörper der Linsen bilden, miteinander verbunden sind, so dass bei Gießen der Linsen ein Niveauabgleich des Gussmittels stattfinden kann, und nachfolgend eine Vereinzelung in die optoelektronischen Bauelemente erfolgt.

2. Verfahren zur Herstellung eines optoelektronischen Bauelementes mit einem strahlungsempfangenden oder strahlungsemittierenden Halbleiterchip (1), der an oder auf einem Sockelteil (4) befestigt und mit wenigstens zwei für die elektrische Kontaktgabe des Bauelementes dienenden Elektrodenanschlüssen (2, 3) aus einem elektrisch leitenden Anschluss-Material verbunden ist, wobei
- die Elektrodenanschlüsse durch eine auf den äußeren Oberflächen des Sockelteils (4) abgeschiedene strukturierte, dünne Beschichtung (16) ausgebildet werden,
- das Sockelteil (4) ein Kunststoff-Sockelteil ist, in das eine Wärmesenke (13) aus thermisch leitendem Material eingearbeitet ist,
- die Wärmesenke sich in thermischem Kontakt mit dem Halbleiterchip (1) befindet,
- sich ein erster Elektrodenanschluss (2) der Elektrodenanschlüsse (2, 3) ausgehend von einem Abschnitt (5) auf einer dem Halbleiterchip zugewandten Oberseite des Sockelteils über randseitige Abschnitte (6) hinweg bis zu Abschnitten (7) auf der Unterseite des Sockelteils (4) erstreckt, sich ein zweiter Elektrodenanschluss (3) der Elektrodenanschlüsse (2, 3) ausgehend von der dem Halbleiterchip zugwandten Oberseite des Sockelteils (4) über randseitige Abschnitte des Sockelteils (4) bis zur Unterseite des Sockelteils (4) erstreckt und der Halbleiterchip auf dem Abschnitt (5) auf der Oberseite des ersten Elektrodenanschlusses (2) befestigt ist,
- das Sockelteil (4) mit der dünnen Beschichtung (16, 16a) aus dem elektrisch leitenden Anschluss-Material durch chemische Abscheidung aus einer Flüssigkeit ohne Einwirkung eines äußeren elektrischen Stromflusses, überzogen wird,
- auf der dünnen Sockelteil-Beschichtung eine Maskenschicht (21) abgeschieden wird,
- die Maskenschicht (21) strukturiert wird, wodurch von dem Maskenmaterial abgedeckte und nicht abgedeckte Bereiche der Sockelteil-Beschichtung ausgewiesen werden,
- selektiv die nicht durch das Material der Maskenschicht abgedeckten Bereiche durch Ätzen entfernt werden,
- gleichzeitig mehrere optoelektronische Bauelemente gefertigt werden, und jeweils eine Linse aufgebracht wird, wobei zur Fertigung der Linsen eine Formenplatte zum Gießen der Linsen eingesetzt wird, die so gestaltet ist, dass die einzelnen Linsenformen, die die Linsenkörper der Linsen bilden, miteinander verbunden sind, so dass bei Gießen der Linsen ein Niveauabgleich des Gussmittels stattfinden kann, und nachfolgend eine Vereinzelung in die optoelektronischen Bauelemente erfolgt.

3. Verfahren nach Anspruch 1 oder 2,
**dadurch gekennzeichnet,**
**dass** die Strukturierung der Sockelteil-Beschichtung (16) oder der Maskenschicht (21) unter der Einwirkung eines Teilchen- oder Lichtstrahls, insbesondere Laserstrahls erfolgt.

4. Verfahren nach einem der Ansprüche 1 bis 3,
dadurch **gekennseichnet**,
dass das selektive Entfernen der nicht verstärkten oder nicht abgedeckten Bereiche der Sockelteil-Beschichtung durch chemisches Nassätzen erfolgt.

5. Verfahren nach einem der Ansprüche 1 bis 4,
**dadurch gekennzeichnet,**
**dass** die Beschichtung (16) des Sockelteils (4) mit dem elektrisch leitenden Anschluss-Material allseitig erfolgt.

6. Verfahren nach einem der Ansprüche 1 bis 5,
**dadurch gekennzeichnet,**
**dass** das Anschluss-Material der Sockel-Beschichtung Kupfer aufweist.

7. Verfahren nach einem der Ansprüche 1 bis 6,
**dadurch gekennzeichnet,**
**dass** das Sockelteil (4) im Spritzguosverfahren vorgefertigt wird.

8. Verfahren nach Anspruch 2 oder einem der Ansprüche 3 bis 7 unter Rückbezug auf Anspruch 2,
**dadurch gekennzeichnet,**
**dass** das Material der Maskenschicht (21) Zinn aufweist.

## Claims

1. Method for producing an optoelectronic device with a radiation-receiving or radiation-emitting semiconductor chip (1) which is mounted to or on a base part (4) and is connected with at least two electrode terminals (2, 3) of an electrically conductive terminal material serving in electrical contacting of the device, wherein
- the electrode terminals are formed by a patterned, thin coating (16) deposited on the outer surfaces of the base part (4),
- the base part (4) is a plastics base part, into which a heat sink (13) of thermally conductive material has been incorporated,
- the heat sink is situated in thermal contact with the semiconductor chip (1),
- a first electrode terminal (2) of the electrode terminals (2, 3) extends from a portion (5) on a top of the base part facing the semiconductor chip over peripheral portions (6) as far as portions (7) on the bottom of the base part (4), a second electrode terminal (3) of the electrode terminals (2, 3) extends from the top of the base part (4) facing the semiconductor chip over peripheral portions of the base part (4) as far as the bottom of the base part (4), and the semiconductor chip is mounted on the portion (5) on the top of the first electrode terminal (2),
- the base part (4) is coated with the thin coating (16) of the electrically conductive terminal material by chemical deposition from a liquid without the action of an external electric current flow,
- the thin coating (16) on the base part (4) is patterned, resulting in the fabrication of individual, electrically mutually insulated regions (18, 19) of the coating (16),
- a further thin layer (20) of an auxiliary material is deposited selectively on a number of predetermined ones (18) of the accordingly fabricated regions of the thin coating (16) by electrodeposition under the action of an external electric current flow, whereby the layer thickness of these predetermined regions (18) of the coating (16) is increased,
- the regions (19) of the base part coating not of increased thickness are selectively removed by etching, and
- a plurality of optoelectronic devices are fabricated simultaneously, and in each case a lens (12) is applied, wherein to fabricate the lenses a mold plate is used to cast the lenses which is configured such that the individual lens molds, which form the bodies of the lenses, are connected together, such that on casting of the lenses leveling of the casting compound may take place, singulation into the optoelectronic devices proceeding thereafter.

2. Method for producing an optoelectronic device with a radiation-receiving or radiation-emitting semiconductor chip (1) which is mounted to or on a base part (4) and is connected with at least two electrode terminals (2, 3) of an electrically conductive terminal material serving in electrical contacting of the device, wherein
- the electrode terminals are formed by a patterned, thin coating (16) deposited on the outer surfaces of the base part (4),
- the base part (4) is a plastics base part, into which a heat sink (13) of thermally conductive material has been incorporated,
- the heat sink is situated in thermal contact with the semiconductor chip (1),
- a first electrode terminal (2) of the electrode terminals (2, 3) extends from a portion (5) on a top of the base part facing the semiconductor chip over peripheral portions (6) as far as portions (7) on the bottom of the base part (4), a second electrode terminal (3) of the electrode terminals (2, 3) extends from the top of the base part (4) facing the semiconductor chip over peripheral portions of the base part (4) as far as the bottom of the base part (4), and the semiconductor chip is mounted on the portion (5) on the top of the first electrode terminal (2),
- the base part (4) is coated with the thin coating (16, 16a) of the electrically conductive terminal material by chemical deposition from a liquid without the action of an external electric current flow,
- a mask layer (21) is deposited on the thin base part coating,
- the mask layer (21) is patterned, whereby regions of the base part coating covered and not covered by the mask material are identified,
- the regions not covered by the material of the mask layer are selectively removed by etching,
- a plurality of optoelectronic devices are fabricated simultaneously, and in each case a lens is applied, wherein to fabricate the lenses a mold plate is used to cast the lenses which is configured such that the individual lens molds, which form the bodies of the lenses, are connected together, such that on casting of the lenses leveling of the casting compound may take place, singulation into the optoelectronic devices proceeding thereafter.

3. Method according to claim 1 or 2,
**characterized in that**
patterning of the base part coating (16) or of the mask layer (21) proceeds under the action of a particle or light beam, in particular laser beam.

4. Method according to one of claims 1 to 3,
**characterized in that**
selective removal of the regions of the base part coating not of increased thickness or not covered proceeds by wet chemical etching.

5. Method according to one of claims 1 to 4,
**characterized in that**
coating (16) of the base part (4) with the electrically conductive terminal material proceeds on all sides.

6. Method according to one of claims 1 to 5,
**characterized in that**
the terminal material of the base coating comprises copper.

7. Method according to one of claims 1 to 6,
**characterized in that**
the base part (4) is prefabricated using the injection molding process.

8. Method according to claim 2 or one of claims 3 to 7 with reference to claim 2,
**characterized in that**,
the material of the mask layer (21) comprises tin.

## Revendications

1. Procédé de fabrication d'un composant optoélectronique muni d'une puce à semi-conducteur (1) réceptrice de rayonnement ou émettrice de rayonnement, laquelle est fixée contre ou sur une partie de socle (4) et est reliée à au moins deux bornes d'électrode (2, 3) servant à la mise en contact électrique du composant, constituées d'une matière de connexion électroconductrice,
- les bornes d'électrode étant réalisées par un revêtement (16) mince, structuré, déposé sur les surfaces extérieures de la partie de socle (4),
- la partie de socle (4) étant une partie de socle en matière plastique, dans laquelle est intégré un puits thermique (13) en matière thermiquement conductrice,
- le puits thermique se trouvant en contact thermique avec la puce à semi-conducteur (1),
- une première borne d'électrode (2) des bornes d'électrode (2, 3), en partant d'une section (5) située sur un côté supérieur de la partie de socle, tourné vers la puce à semi-conducteur, s'étendant au-delà de sections (6) côté bord jusqu'à des sections (7) situées sur le côté inférieur de la partie de socle (4), une deuxième borne d'électrode (3) des bornes d'électrode (2, 3), en partant du côté supérieur de la partie de socle (4), tourné vers la puce à semi-conducteur, s'étendant au-delà de sections côté bord de la partie de socle (4) jusqu'au côté inférieur de la partie de socle (4), et la puce à semi-conducteur étant fixée sur la section (5) située sur le côté supérieur de la première borne d'électrode (2),
- la partie de socle (4) munie du revêtement (16) mince, constitué de matière de connexion électroconductrice, étant enrobée par déposition chimique à partir d'un liquide, sans action d'un flux électrique extérieur,
- le revêtement (16) mince de la partie de socle (4) étant structuré et des zones (18, 19) individuelles, électriquement isolées les unes des autres, du revêtement (16) étant en même temps fabriquées,
- une couche (20) mince supplémentaire constituée d'une matière auxiliaire étant déposée par déposition galvanique avec action d'un flux de courant électrique extérieur de manière sélective sur certaines zones prédéterminées (18) des zones ainsi fabriquées du revêtement mince (16), sur quoi l'épaisseur de couche de ces zones prédéterminées (18) du revêtement (16) est renforcée,
- les zones (19) non renforcées du revêtement de la partie de socle étant enlevées sélectivement par gravure, et
- plusieurs composants optoélectroniques étant fabriqués simultanément, et une lentille (12) étant respectivement appliquée, une plaque de moulage destinée au moulage des lentilles étant utilisée pour la fabrication des lentilles, laquelle est conçue de manière à ce que les formes de lentille individuelles qui forment les corps des lentilles soient reliées entre elles de sorte que lors du moulage des lentilles, une compensation de niveau de l'agent de coulage peut avoir lieu, et qu'ensuite une séparation dans les composants optoélectroniques a lieu.

2. Procédé de fabrication d'un composant optoélectronique muni d'une puce à semi-conducteur (1) réceptrice de rayonnement ou émettrice de rayonnement, laquelle est fixée contre ou sur une partie de socle (4) et est reliée à au moins deux bornes d'électrode (2, 3) servant à la mise en contact électrique du composant, constituées d'une matière de connexion électroconductrice,
- les bornes d'électrode étant réalisées par un revêtement (16) mince, structuré, déposé sur les surfaces extérieures de la partie de socle (4),
- la partie de socle (4) étant une partie de socle en matière plastique, dans laquelle est intégré un puits thermique (13) en matière thermiquement conductrice,
- le puits thermique se trouvant en contact thermique avec la puce à semi-conducteur (1),
- une première borne d'électrode (2) des bornes d'électrode (2, 3), en partant d'une section (5) située sur un côté supérieur de la partie de socle, tourné vers la puce à semi-conducteur, s'étendant au-delà de sections (6) côté bord jusqu'à des sections (7) situées sur le côté inférieur de la partie de socle (4), une deuxième borne d'électrode (3) des bornes d'électrode (2, 3), en partant du côté supérieur de la partie de socle (4), tourné vers la puce à semi-conducteur, s'étendant au-delà de sections côté bord de la partie de socle (4) jusqu'au côté inférieur de la partie de socle (4), et la puce à semi-conducteur étant fixée sur la section (5) située sur le côté supérieur de la première borne d'électrode (2),
- la partie de socle (4) munie du revêtement (16) mince, constitué de matière de connexion électroconductrice, étant enrobée par déposition chimique à partir d'un liquide, sans action d'un flux électrique extérieur,
- une couche de masquage (21) étant déposée sur le revêtement mince de la partie de socle,
- la couche de masquage (21) étant structurée, sur quoi des zones recouvertes par la matière de masquage et des zones non recouvertes par la matière de masquage du revêtement de la partie de socle apparaissent,
- les zones non recouvertes par la matière de la couche de masquage étant sélectivement enlevées par gravure,
- plusieurs composants optoélectroniques étant fabriqués simultanément, et une lentille étant respectivement appliquée, une plaque de moulage destinée au moulage des lentilles étant utilisée pour la fabrication des lentilles, laquelle est conçue de manière à ce que les formes de lentille individuelles qui forment les corps des lentilles soient reliées entre elles de sorte que lors du moulage des lentilles, une compensation de niveau de l'agent de coulage peut avoir lieu, et qu'ensuite une séparation dans les composants optoélectroniques a lieu.

3. Procédé selon la revendication 1 ou 2,
**caractérisé en ce**
**que** la structure du revêtement (16) de la partie de socle ou de la couche de masquage (21) est réalisée sous l'action d'un rayon de particules ou d'un rayon lumineux, notamment d'un rayon laser.

4. Procédé selon l'une quelconque des revendications 1 à 3,
**caractérisé en ce**
**que** l'enlèvement sélectif des zones non renforcées ou non recouvertes du revêtement de la partie de socle est réalisé par gravure humide chimique.

5. Procédé selon l'une quelconque des revendications 1 à 4,
**caractérisé en ce**
**que** le revêtement (16) de la partie de socle (4) à l'aide de la matière de connexion électroconductrice est réalisé sur tous les côtés.

6. Procédé selon l'une quelconque des revendications 1 à 5,
**caractérisé en ce**
**que** la matière de connexion du revêtement de socle présente du cuivre.

7. Procédé selon l'une quelconque des revendications 1 à 6,
**caractérisé en ce**
**que** la partie de socle (4) est préfabriquée selon le procédé de moulage par injection.

8. Procédé selon la revendication 2 ou selon l'une quelconque des revendications 3 à 7 en faisant renvoi à la revendication 2,
**caractérisé en ce**
**que** la matière de la couche de masquage (21) présente de l'étain.
